# EUROPEAN PATENT APPLICATION

(11) **EP 2 549 524 A1**
(43) Date of publication of application: **23.01.2013**
(21) Application number: 11755925.2
(22) Date of filing: 17.03.2011
(51) Int. Cl.: H01L 21/31, C23C 16/455

(54) **THIN-FILM FORMING DEVICE**

(30) Priority: 18.03.2010 JP 2010062208
(71) Applicant: Mitsui Engineering & Shipbuilding Co., Ltd., Chuo-ku Tokyo 104-8439 (JP)
(72) Inventor: HATTORI, Nozomu, Tamano-shi Okayama 706-8651 (JP); MORI, Yasunari, Tamano-shi Okayama 706-8651 (JP)
(86) International application number: PCT/JP2011/001569
(87) International publication number: WO 2011/114734

(57) **Abstract**

This thin-film forming device includes: a deposition vessel in which a reduced-pressure deposition space, to which a raw material gas and a reactant gas are alternately supplied on different timings, is formed in order to form a thin film on the substrate; and a gas supply unit configured to supply the raw material gas and the reactant gas to the deposition vessel. The gas supply unit is provided with at least one partition that bends a gas passage from an inlet port of each of the raw material gas and the reactant gas toward the deposition space.

## Description

### Technical Field

The present invention relates to a thin-film forming device that forms a thin film on a substrate.

### Background Art

Nowadays an Atomic Layer Deposition method (hereinafter an ALD method), in which a thin film is formed on a substrate in a unit of an atomic layer or in units of atomic layers, attracts attention as a thin-film forming method. In the ALD method, two kinds of gases mainly containing elements constituting the film to be formed are alternately supplied onto a deposition-target substrate so as to form thin films in a unit of an atomic layer or in units of atomic layers a plurality of times, thereby forming the film having a desired thickness. For example, a raw material gas containing TMA (Tri-Methyl Aluminum) and an oxidation gas containing oxygen are used when an Al₂O₃ film is formed on the substrate. A nitriding gas is used instead of the oxidation gas when a nitride film is formed on the substrate.

What is called a self-limit function of growth is used in the ALD method. In the self-limit function, only one or several layers of raw material-gas component adsorb on the substrate surface while the raw material gas is supplied, and the excess raw material gas does not contribute to the growth.

The ALD method has a high step coverage and high film-thickness controllability compared with a general CVD (Chemical Vapor Deposition) method. Therefore, the ALD method is expected to be applied to formation of a capacitor of a memory element and an insulating film called a "high-k gate". Additionally, in the ALD method, the insulating film can be formed at a low temperature of about 300°C. Therefore, the ALD method is expected to be applied to formation of a gate insulator of a thin-film transistor for a display device using a glass substrate such as a liquid crystal display.

In the ALD method, a deposition gas, such as a raw material gas and a reactant gas, is supplied to a deposition space so as to flow toward the substrate from a direction parallel to a substrate surface. Alternatively, the deposition gas is supplied so as to flow toward the substrate from a shower head, which is provided vertically above the substrate.
For example, Patent Literature 1 discloses a system in which the deposition gas flows in the direction parallel to the substrate surface. For example, Patent Literature 2 discloses a system in which the shower head is employed.

### Citation list

### Patent literature

Patent Literature 1: Japanese Patent Application Laid-Open No. 2009-206312
Patent Literature 2: Japanese Patent Application Laid-Open No. 2009-191311

The thin film can be buried even in a fine recess with the high step coverage by the ALD method.

However, in the case of the system that supplies the gas employing the shower head, it is necessary that the shower head fits to a substrate size on which a thin film is formed. The bigger a substrate is, the less performed the degassing of the shower head is. As a result, a gas phase reaction in which a reaction product is obtained is easily carried out.

On the other hand, in the case of the system in which the deposition gas flows in the direction parallel to the substrate surface, sometimes the film is formed to have an ununiform thickness and a quality on a gas supply side and a gas discharge side on the substrate.

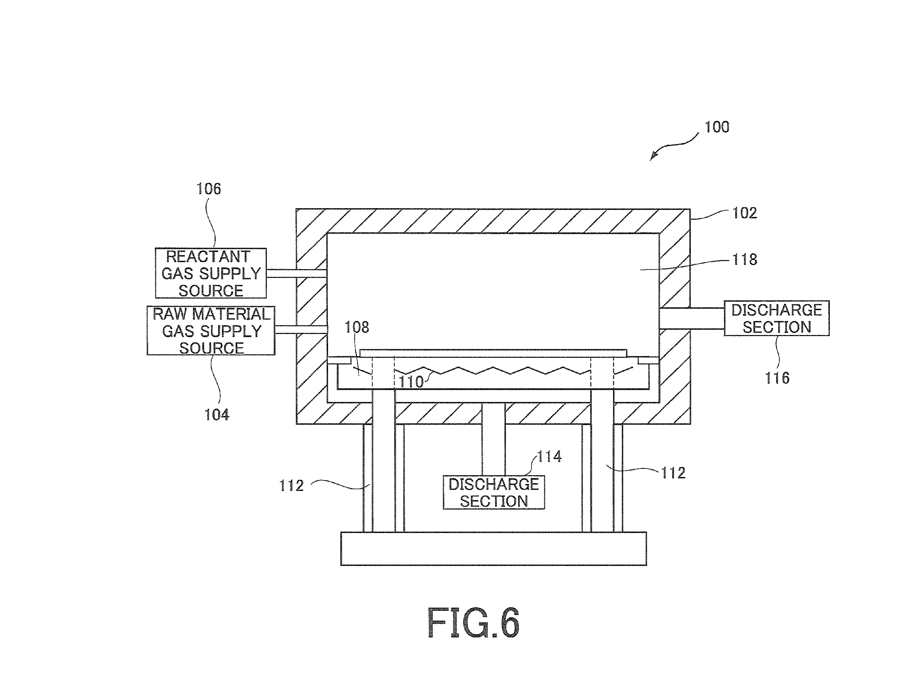

Fig. 6 illustrates an example of a thin-film forming device 100 in which the thin film is formed by the ALD.

The thin-film forming device 100 includes a deposition vessel 102, a raw material gas supply section 104, a reactant gas supply section 106, a substrate stage 108, a heater 110, lifting and lowering mechanisms 112, and discharge sections 114 and 116.

In the deposition space of the deposition vessel 102, a component of the TMA gas supplied from the raw material gas supply section 104 adsorbs on the substrate, which is placed on the substrate stage 108 and heated by the heater 110. The deposition space of the deposition vessel 102 is made to be a reduced-pressure state by the discharge sections 114 and 116.

The reactant gas supply section 104 supplies the oxidation gas that is a reactant gas into the deposition vessel 102 in a direction parallel to the substrate surface. The oxidation gas is heated near the substrate that is heated by the heater 110, and a part of the oxidation gas becomes active oxygen to react with the TMA component adsorbing on the substrate, thereby forming the aluminum-oxide thin film.

The excess TMA gas and oxidation gas or oxygen radical, which do not contribute to the formation of the aluminum-oxide thin film, are discharged from the discharge section 16 through a discharge pipe.

However, the thin film formed on the substrate is thicker toward a side of the raw material gas supply, and even the quality of the thin film on the side of the raw material gas supply may differ from that on the side of the discharge section 116.

### Summary of Invention

### Technical Problem

An object of the invention is to provide a thin-film forming device capable of forming a thin film uniformly compared with the conventional thin-film forming device.

### Means to Solve the problem

An aspect of the present invention is a thin-film forming device for forming a thin film on a substrate. The thin-film forming device includes:
a deposition vessel encompassing a reduced-pressure deposition space in order to form the thin film on the substrate, the reduced-pressure deposition space being configured to be alternately supplied with a raw material gas and a reactant gas at different times; and
a gas supply unit configured to supply each of the raw material gas and the reactant gas to the deposition vessel,
wherein at least one partition that bends a gas passage from an inlet port of each of the raw material gas and the reactant gas toward the deposition space is provided in the gas supply unit.

Preferably, the partition is provided such that a wall surface of the partition is located on a forward position of a flow direction of each of the raw material gas and the reactant gas flowing through the inlet port of the gas supply unit.

In the device, the gas supply unit preferably includes a heater that keeps the partition at a constant temperature. The partition is preferably heated to a temperature at which the raw material gas does not condensed.

The thin-film forming device further includes a substrate stage on which the substrate is to be placed. The gas supply unit preferably causes the raw material gas and the reactant gas to flow in a direction parallel to a placement surface of the substrate stage on which the substrate is to be placed, and the gas supply unit includes a plurality of partitions, in a partition closest to the deposition space among the plurality of partitions, a plurality of slit pores extend in a direction perpendicular to the placement surface of the substrate stage, and the plurality of slits are arranged in parallel to the placement surface.

The thin-film forming device further includes a substrate stage on which the substrate is to be placed. The gas supply unit causes the raw material gas and the reactant gas to flow in a direction parallel to a placement surface of the substrate stage on which the substrate is to be placed. Then a gas injection port of the gas supply unit facing the deposition space is preferably a slit-like opening extending in the direction parallel to the placement surface.
The thin-film forming device further includes a substrate stage on which the substrate is to be placed, wherein a plurality of slit pores extending in a direction perpendicular to the placement surface of the substrate stage, on which the substrate is placed, are preferably formed in the gas supply unit in a direction parallel to the placement surface.

The gas supply unit includes a plurality of partitions. The raw material gas and the reactant gas are preferably introduced to different spaces partitioned by one of the plurality of partitions, pass through a gap between the partitions, and then pass through an identical passage.

### Advantageous Effects of Invention

According to the above-mentioned thin-film forming device, the thin film can be formed uniformly compared with the conventional thin-film forming device.

Additionally, a backflow of the gas from the deposition vessel toward a control valve provided on the side of the raw material gas supply can be prevented to suppress the formation and deposition of the film on the control valve.

### Brief Description of Drawings

Fig. 1 is a view illustrating a configuration of an ALD equipment that is an embodiment of the thin-film forming device of the invention.
Figs. 2A and 2B are views illustrating a raw material gas supply unit provided in the ALD equipment in Fig. 1.
Figs. 3A to 3C are views illustrating partitions of the raw material gas supply unit in Fig. 2.
Fig. 4A is a view illustrating formation of a thin film by a conventional thin-film forming device, Fig. 4B is a view illustrating measuring positions of the thin film, and Fig. 4C is a view illustrating a thickness measurement result of the thin film.
Fig. 5 is a view illustrating a configuration of a raw material gas supply unit according to an embodiment different to the embodiment illustrated in FIG. 1.
Fig. 6 is a view illustrating the conventional thin-film forming device.

### Description of Embodiments

Hereinafter, a thin-film forming device and a thin-film forming method of the invention will be described in detail.

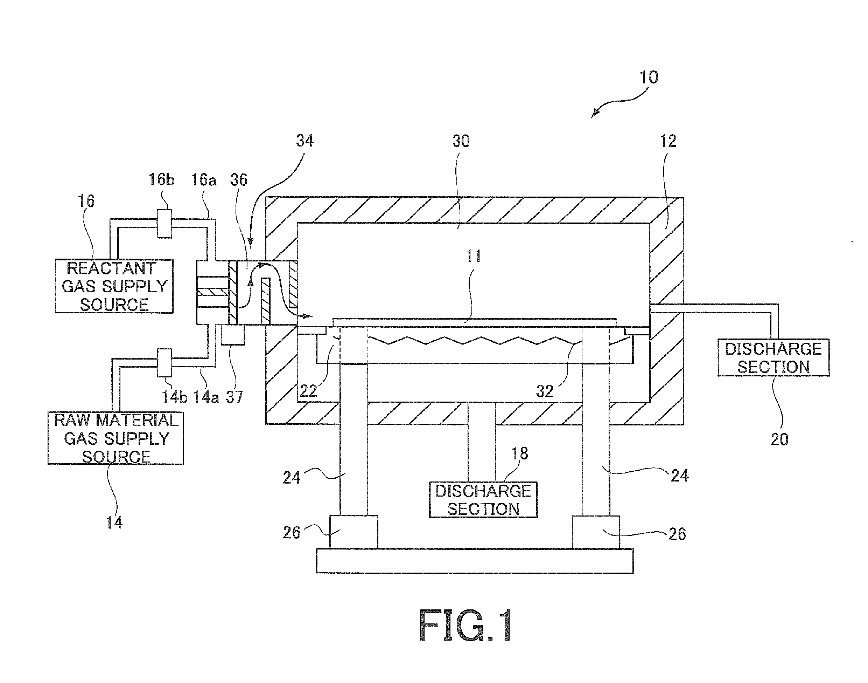

Fig. 1 is a view illustrating a schematic configuration of an ALD equipment according to an embodiment.

In the ALD equipment 10 in Fig. 1, two kinds of deposition gases (a raw material gas and a reactant gas) mainly containing elements constituting the film to be formed are alternately supplied onto a substrate 11 as a deposition target. At this time, an oxide film of the raw material gas is formed on the substrate 11 in a unit of an atomic layer or in units of atomic layers using the reactant gas that is heated to enhance reaction activity. A thin film having a desired thickness is formed by repeating the above process a plurality of cycles, for example, about 100 cycles. The oxidation gas, such as an oxidation gas and an ozone gas, and the nitriding gas, such as a nitrogen gas, are used as the reactant gas.

The ALD equipment 10 essentially includes a deposition vessel 12, a raw material gas supply source 14, a reactant gas supply source 16, discharge sections 18 and 20, a substrate stage 22, lift pins 24, and lifting and lowering mechanisms 26. Hereinafter, a case of forming a metal oxide film of aluminum on the substrate 11 using TMA as the raw material gas and oxidation gas as the reactant gas is described as an example. The same holds true for a nitride film.

The substrate stage 22 and a heater 32 are provided in a deposition space 30 of the deposition vessel 12. The substrate stage 22 is provided below the deposition space 30, and the heater 32 is provided below the substrate stage 22. The substrate 11 is supported by the lift pins 24, which are vertically provided from the outside of the deposition vessel 12 through the substrate stage 22. During the deposition, the substrate 11 is placed on the substrate stage 22. The lift pins 24 can be vertically lifted and lowered by the lifting and lowering mechanisms 26 in order to replace the substrate 11.
The ALD equipment 10 is so-called thermal ALD equipment, in which a thin film is formed while the substrate 11 is heated to about 250°C by the heater 32.

The raw material gas supply source 14 and the reactant gas supply source 16, which supply the raw material gas and the reactant gas into the deposition space 30, are provided in a left sidewall of the deposition vessel 12 in Fig. 1.
The raw material gas supply source 14 supplies the TMA gas that is a raw material gas to the deposition space 30 through the supply pipe 14a. The supply of the raw material gas is controlled by a control valve 14b. A TMA component adsorbs on the substrate 11 by the supply of the raw material gas to the deposition space 30.
The reactant gas supply source 16 supplies the oxidation gas that is a reactant gas to the deposition space 30 through a supply pipe 16a. The supply of the oxidation gas is controlled by a control valve 16b. The oxidation gas is supplied when the supply of the TMA gas is stopped. That is, the TMA gas and the oxidation gas are alternately supplied to the deposition space 30. The oxidation gas is made to a high-temperature state near the substrate 11 of the deposition space 30, a part of the oxidation gas becomes active oxygen, and the active oxygen reacts with the TMA component adsorbing on the substrate 11, thereby forming a thin film of metal oxide film.
In addition, an inert gas, such as the nitrogen gas, is supplied as a purge gas to the deposition space 30 from a purge-gas supply section (not illustrated) in the intervals between the alternate supply of the TMA gas that is a raw material gas and the oxidation gas that is a reactant gas to the deposition space 30. Therefore, the TMA gas and the oxidation gas are replaced efficiently with each other.
Both the raw material gas and the reactant gas are supplied to the deposition space 30 through a gas supply unit 34. The gas supply unit 34 is described later.

Because a thin film is formed in a unit of an atomic layer or in units of atomic layers, the adsorption of TMA on the substrate 11 and the reaction of TMA with the active oxygen are performed in an extremely short time. For example, TMA reacts with the active oxygen in a several milliseconds. At this time, for example, the oxidation gas flows onto the substrate 11 for about one second in order to perform the reaction uniformly all over the substrate 11. A thin film having a thickness of several nanometers to tens of nanometers can be formed by alternately supplying the TMA gas and the oxidation gas.

The deposition vessel 12 is always maintained in a predetermined vacuum level (for example, about 10 Pa to 100 Pa, or several pascals to hundreds of pascals) by discharging the TMA gas, the oxidation gas, and the purge gas through the discharge sections 18 and 20. The discharge section 18 includes a discharge pipe, which extends from a discharge port provided in a floor surface below the substrate stage 22 in the deposition vessel 12, and a pump. The discharge pipe communicates with a lower space of the deposition vessel 12.
The discharge section 20 includes a discharge pipe, which extends from a discharge port provided in a right side surface of the deposition vessel 12 in Fig. 1, and a pump. The discharge pipe communicates with the deposition space 30.

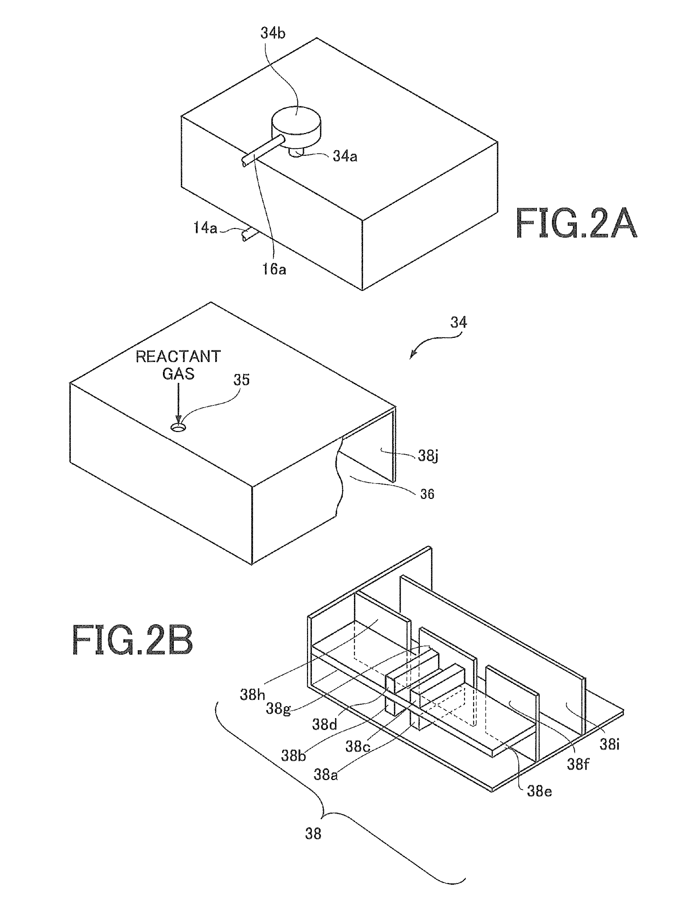

Figs. 2A and 2B are views illustrating the gas supply unit 34 that supplies the TMA gas and the oxidation gas to the deposition space 30. For the purpose of understanding the internal structure, Fig. 2B illustrates the gas supply unit 34 with its sidewalls removed.
The gas supply unit 34 is formed into a box-shaped vessel so as to include an internal space 36, and a pipe 34a projecting from a reactant gas inlet port of the gas supply unit 34 communicates with the supply pipe 16a through a joint member 34b. Although not illustrated, a pipe projecting from the gas supply unit 34 communicates with the supply pipe 14a through a joint member on the back surface side of the gas supply unit 34.
A main body portion of the gas supply unit 34 is configured such that an internal space surrounded by wall surfaces in every direction is partitioned by a plurality of partitions to bend passages of the TMA gas that is a raw material gas and the oxidation gas that is a reactant gas.
A heater 37 is provided in the gas supply unit 34 in order to keep metallic partitions 38 at a constant temperature. The reason the metallic partitions 38 are kept at the constant temperature of 75°C or more, for example is that the TMA gas that is a raw material gas is not cooled when colliding with the partitions 38, and thus not condensed.

Fig. 2B is an exploded perspective view illustrating the internal structure of the gas supply unit 34.
In the internal space 36 of the gas supply unit 34, the plurality of partitions 38 are provided to form a plurality of chambers. Each of the partitions 38 is vertically provided from the wall surface of the gas supply unit 34 or another partition 38 so as to bend the passages of the gas flowing from the raw material gas and reactant gas inlet ports toward the deposition space 30.

Specifically, partitions 38a to 38d are provided on a partition 38e to be described later in the order from the TMA-gas and oxidation-gas inlet ports. Fig. 2B illustrates an inlet port 35 of the oxidation gas that is a reactant gas. The partitions 38a and 38b are provided downward from the lower surface of the partition 38e, and the partitions 38c and 38d are provided upward from the upper surface of the partition 38e. Leading ends of the partitions 38a to 38d do not contact with any inner wall surface (a ceiling surface or a floor surface) of the gas supply unit 34, but a gap is formed between the leading ends of the partition 38a to 38d and inner wall surfaces of the gas supply unit 34. The gap is a part of the passages in which the TMA gas and the oxidation gas supplied from the inlet ports flow while turning.

The partition 38e is provided perpendicularly to partitions 38f, 38g, and 38h to be described later. Because the partitions 38f, 38g, and 38h are provided perpendicularly to the inner wall surface of the gas supply unit 34, the partition 38e is provided in parallel to the inner wall surface of the gas supply unit 34, and the partition 38e divides, on the side of the inlet port, an internal space into two upper and lower spaces which are respectively partitioned by the partitions 38f, 38g, and 38h. The partition 38e divides the internal space into two upper and lower spaces in order to separate the oxidation gas introduced from above and the TMA gas introduced from below when introduced. By separating the oxidation gas introduced from above and the TMA gas introduced from below when introduced, even if the TMA gas is condensed into a TMA liquid to adhere to the wall surface, the TMA liquid hardly has a chance to react with the oxidation gas, and thus a reaction product is not generated.
The partition 38e is provided such that the wall surfaces of the partition 38e are located on the forward position of the flow direction of each of the raw material gas and the reactant gas flowing through the inlet ports of the gas supply unit 34. The partition 38e is provided as described above in order to stop the flows of the raw material gas and the oxidation gas, which are introduced from the inlet ports, for a moment.

The partitions 38f, 38g, and 38h are provided perpendicularly to the inner wall surface of the gas supply unit 34. The partitions 38f, 38g, and 38h are unidirectionally aligned in line, and gaps are provided between the partition 38f and the partition 38g and between the partition 38g and the partition 38h to form slit-like pores. The slit-like pores are parts of the passages of the gases supplied to the two upper and lower internal spaces, which are divided by the partition 38e, thereby forming an internal space between the partitions 38f, 38g, and 38h and a partition 38i to be described later. The internal space is commonly used as the passage of the TMA gas and the oxidation gas. This means that the raw material gas and the reactant gas introduced to different spaces divided by the partition 38e flow through the gaps of the partitions 38f, 38g, and 38h into the passages of the same space. The reason the internal space can be commonly used as the passage of the TMA gas and the oxidation gas is that an amount of TMA gas to be condensed is already condensed in the reduced-pressure atmosphere so that the TMA liquid does not adhere to the partition 38i.

The partition 38i is provided perpendicularly to an inner wall surface (the floor surface) of the gas supply unit 34. The leading end of the partition 38i does not contact with an inner wall surface (the ceiling surface) of the gas supply unit 34, but a gap is formed between the leading end of the partition 38i and the inner wall surface (the ceiling surface) of the gas supply unit 34. The gap is commonly used as the passage of the TMA gas and the oxidation gas. The reason the gap can be commonly used as the passage of the TMA gas and the oxidation gas is that, the amount of TMA gas to be condensed is already condensed in the reduced-pressure atmosphere so that the TMA liquid does not adhere to the partition 38i.

A partition 38j is downwardly provided perpendicularly to the inner wall surface (the ceiling surface) of the gas supply unit 34. The leading end of the partition 38j does not contact with an inner wall surface (the floor surface) of the gas supply unit 34, but a gap is formed between the leading end of the partition 38j and the inner wall surface (the floor surface) of the gas supply unit 34. The gap is a part of the passages of the TMA gas and the oxidation gas, and is commonly used as an injection port to the deposition space 30. The reason the gap can be commonly used as the passage of the TMA gas and the oxidation gas is that the amount of TMA gas to be condensed is already condensed in a reduced-pressure atmosphere so that the TMA liquid does not adhere to the partition 38j.

When the partitions 38f, 38g, and 38h are viewed as one partition, the plurality of slit pores extend perpendicularly to the placement surface of the substrate on the substrate stage 22, and the alignment direction of the plurality of slits is parallel to the placement surface. Therefore, the gas flowing from the slit pores between the partitions 38f, 38g, and 38h can flow all over the width of the deposition space 30.
Since the injection port formed by the partition 38i is a slit-like opening extending in the direction parallel to the placement surface of the substrate stage 22, the gas can substantially uniformly flow all over the width of the substrate 11.

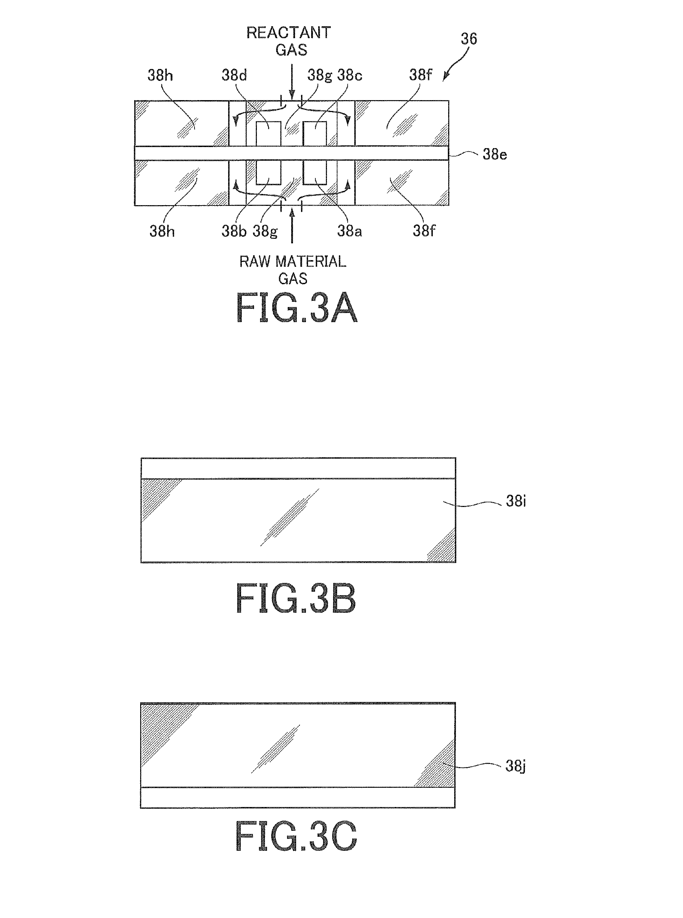

Fig. 3A illustrates an aspect of the partitions 38a to 38h and the formed slit-like pores (white regions in Fig. 3A) when the side of the deposition space 30 is viewed from the inlet port side. The flow of the oxidation gas that is a reactant gas introduced from above in the figure and the TMA gas that is a raw material gas introduced from below in the figure are indicated by arrows.
Fig. 3B illustrates the slit-like pore (a white region in Fig. 3B) formed by the partition 38i when the internal space between the partitions 38f, 38g, and 38h and the partition 38i is viewed towards the side of the deposition space 30.
Fig. 3C illustrates the slit-like pore (a white region in Fig. 3C) formed by the partition 38j when the internal space between the partition 38i and the partition 38j is viewed towards the side of the deposition space 30.

As described above, in the gas supply unit 34, the passages of the TMA gas and the reactant gas are bent by providing the plurality of partitions. The reason the passages are bent in such a manner is that, preferably the flow rates of the TMA gas and the oxidation gas are suppressed as much as possible so that the TMA gas and the oxidation gas flow at a rate close to gas diffusion from the viewpoint of improving the uniformity of the thin film. As described later, in a thin film formed by the gas supply unit 34 of the invention, it is found that a distribution of the thickness is substantially uniform compared with the conventional thin-film forming device in which the gas is supplied by a shower head.

### [Example]

A thin film was formed on a substrate in order to confirm the effect of the thin-film forming device of the invention (an example).

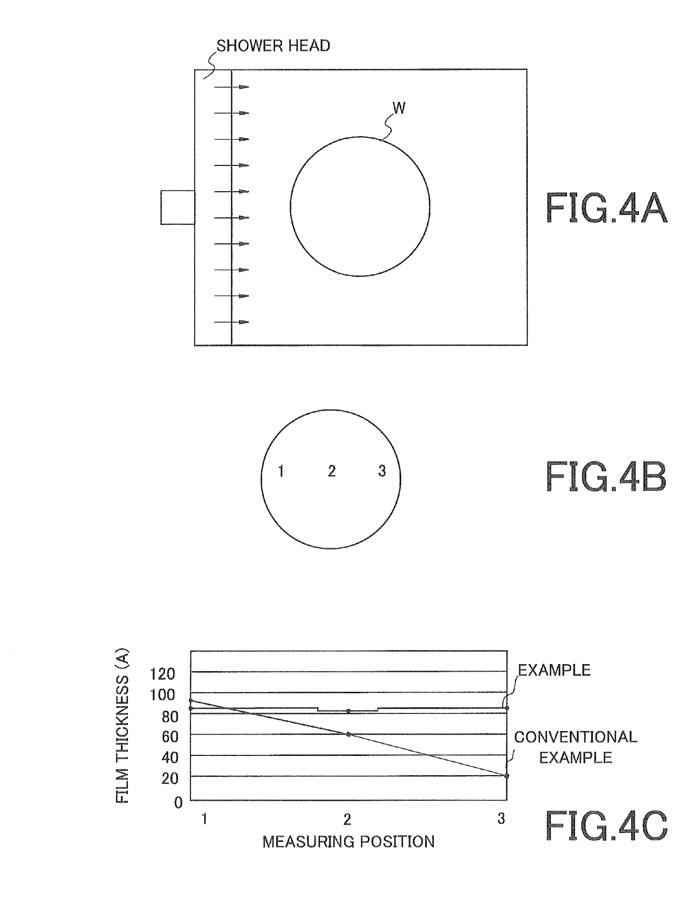

Fig. 4A illustrates an example (a conventional example) in which a thin film is formed on a substrate using the conventional shower head with the TMA gas that is a raw material gas and the ozone gas that is a reactant gas. In this example, the shower head is located such that the gas flows in the direction parallel to a substrate- placement surface on the substrate stage.
In both the example and the conventional example, circular silicon substrates (6-inch wafers) are used and aluminum oxide films were formed thereon.
The substrate temperature was set to 250°C, the TMA gas of 0.5 mg was supplied every time, a single process time necessary for supply of the TMA gas, discharge of the TMA gas, supply of the ozone gas, and discharge of the ozone gas was set to 8.5 seconds, and the process was repeated 100 times.
Fig. 4B illustrates three points at each of which the thickness of the film formed on the silicon substrate was measured. A point 1 is a position on the upstream side (the gas-supply side) of the gas flow, and a point 3 is a position on the downstream side (the discharge side) of the gas flow.
Fig. 4C illustrates thickness distributions of the thin films, which are the measurement results of the example and the conventional example. As can be seen from Fig. 4C, in the conventional example, the film thickness increases toward the upstream side while decreases toward the downstream side. On the other hand, in the example, the thin film having the substantially uniform thickness was formed.
Thus, the advantageous effect of the invention was confirmed.

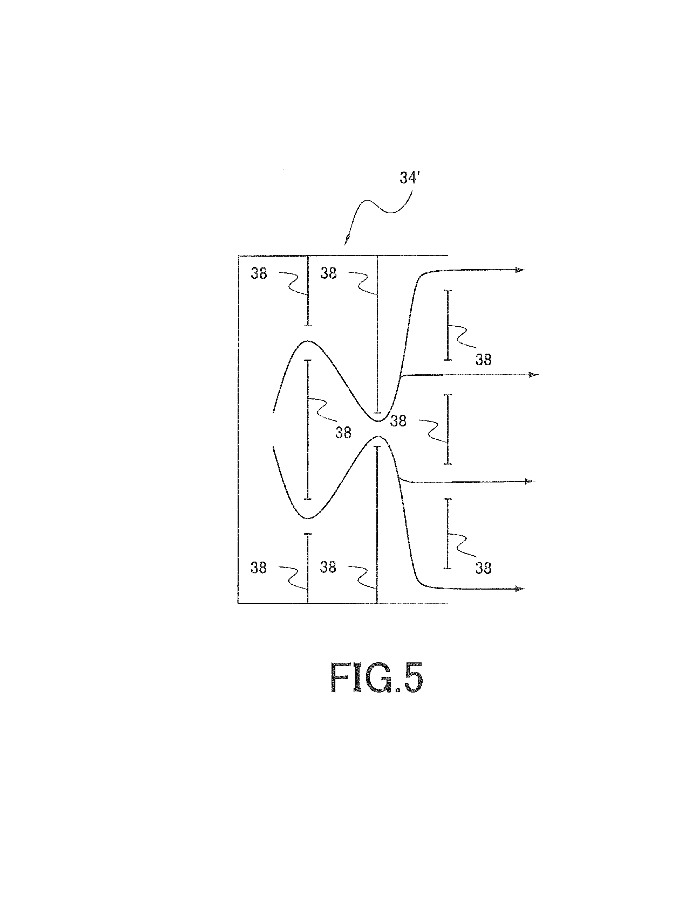

In the embodiment, the plurality of partitions are arranged as illustrated in Fig. 2B. However, the arrangement of the partitions is not limited thereto. The partitions may be arranged in any way as long as the partitions bend the passages of the raw material gas and the reactant gas. For example, the partitions 38 may be arranged in a gas supply unit 34' in Fig. 5. Fig. 5 is a plan view of a diagrammatic drawing illustrating the arrangement of the partitions 38. All the partitions 38 are vertically provided from an inner wall surface (the floor surface) of the gas supply unit 34', and gaps are provided between the partitions 38, thereby bending the gas passages. Also in the passages in Fig. 5, the partitions 38 are provided such that a wall surface of a partition 38 is located on a forward position of a flow direction of each of the raw material gas and the reactant gas flowing through the inlet ports of the gas supply unit 34'.

Although the thin-film forming device of the invention is described above in detail, the thin-film forming device of the invention is not limited to the embodiment. Various changes and modifications can be made without departing from the scope of the invention.

### Reference Sign List

- 10: ALD equipment
- 11: substrate
- 12: deposition vessel
- 14: raw material gas supply source
- 16: reactant gas supply source
- 18, 20: discharge section
- 22: substrate stage
- 24: lift pin
- 26: lifting and lowering mechanism
- 30: deposition space
- 32, 37: heater
- 34: gas supply unit
- 34a: pipe
- 34b: joint member
- 35: inlet port
- 36: internal space
- 38, 38a to 38j: partition

## Claims

1. A thin-film forming device for forming a thin film on a substrate, the thin-film forming device comprising:
a deposition vessel encompassing a reduced-pressure deposition space in order to form the thin film on the substrate, the reduced-pressure deposition space being configured to be alternately supplied with a raw material gas and a reactant gas at different times; and
a gas supply unit configured to supply each of the raw material gas and the reactant gas to the deposition vessel,
wherein at least one partition that bends a gas passage from an inlet port of each of the raw material gas and the reactant gas toward the deposition space is provided in the gas supply unit.

2. The thin-film forming device according to claim 1, wherein the partition is provided such that a wall surface of the partition is located on a forward position of a flow direction of each of the raw material gas and the reactant gas flowing through the inlet port of the gas supply unit.

3. The thin-film forming device according to claim 1 or 2, wherein the gas supply unit includes a heater for keeping the partition at a constant temperature.

4. The thin-film forming device according to claim 3, wherein the partition is configured to be heated to a temperature at which the raw material gas does not condensed.

5. The thin-film forming device according to any one of claims 1 to 4, further comprising a substrate stage for placing the substrate thereon,
wherein the gas supply unit is configured to cause the raw material gas and the reactant gas to flow in a direction parallel to a placement surface of the substrate stage on which the substrate is placed, and
a gas injection port of the gas supply unit facing the deposition space is a slit-like opening extending in the direction parallel to the placement surface.

6. The thin-film forming device according to any one of claims 1 to 5, further comprising a substrate stage for placing the substrate thereon,
wherein a plurality of slit pores extending in a direction perpendicular to the placement surface of the substrate stage for placing the substrate thereon are formed in the gas supply unit in a direction parallel to the placement surface.

7. The thin-film forming device according to any one of claims 1 to 5, wherein the gas supply unit includes a plurality of partitions, and
the plurality of partitions are configured such that the raw material gas and the reactant gas are introduced to different spaces partitioned by one of the plurality of partitions, pass through a gap between the partitions and then pass through an identical passage.

8. The thin-film forming device according to any one of claims 1 to 5, further comprising a substrate stage for placing the substrate thereon,
wherein the gas supply unit is configured to cause the raw material gas and the reactant gas to flow in a direction parallel to the placement surface of the substrate stage for placing the substrate thereon,
the gas supply unit includes a plurality of partitions, in a partition closest to the deposition space among the plurality of partitions, a plurality of slit pores extend in a direction perpendicular to the placement surface of the substrate stage, and the plurality of slits are arranged in parallel to the placement surface.
